# EUROPEAN PATENT APPLICATION

(11) **EP 1 582 273 A1**
(43) Date of publication of application: **05.10.2005**
(21) Application number: 03777369.4
(22) Date of filing: 09.12.2003
(51) Int. Cl.: B09B 5/00

(54) **FRACTIONALLY COLLECTABLE PRODUCT**

(30) Priority: 17.12.2002 JP 2002365755
(71) Applicant: MATSUSHITA ELECTRIC INDUSTRIAL CO., LTD., Kadoma-shi, Osaka 571-8501 (JP)
(72) Inventor: IKEDA, Takumi, Kobe-shi, Hyogo 651-0053 (JP); WATANABE, Kazuhisa, Yokohama-shi, Kanagawa 226-0013 (JP)
(74) Representative: Betten & Resch
(86) International application number: PCT/JP2003/015697
(87) International publication number: WO 2004/054729

(57) **Abstract**

The objective herein is to provide a separately recoverable product, which can be easily disassembled into respective separable materials by persons other than waste collectors, waste-disposal service vendors, and recycling operators. To solve the problems herein, a separately recoverable product is provided with a connection member and a detachment member, which is disassemblable into respective separable materials. Moreover, the detachment member herein utilizes a mechanism for deforming a screw member by way of an explosion means, a melting means, and a shape-memory alloy.

## Description

### TECHNICAL FIELD

The present invention relates to a separately recoverable product, which is disassemblable to respective separately recoverable materials, such as metal or plastics.

### BACKGROUND ART

In the past, for disposal of home appliances (e.g., televisions, personal computers, and mobile phones), waste collectors, waste-disposal service vendors, and recycling operators of such disposed home appliances ordinarily had disassembled and separated them to respective separable materials, followed by waste disposal or recycling. With the advent of the enforcement of the recycling laws, large appliances, such as televisions, refrigerators, and air conditioners, are generally now designed in such a way to facilitate disposal and recycling as such by recycling operators.

As a conventional art, for example, there is an easily disassemblable high-voltage transformer of a microwave oven, which enables separation of an iron core formed by overlapping silicon steel sheets and copper wires (Japanese Patent Publication No. H11-273962). Doing away with the conventional practice of welding the silicon steel sheet, the above conventional art takes the approach of fixing the silicon steel sheet by sandwiching the same with the plate springs. By removing the plate springs, the transformer can be easily disassembled along with copper wires, thereby enabling recovery of highly-pure copper wires as resources.

Meanwhile, with regard to small appliances such as mobile apparatuses as in mobile phones, since they are not subject to the above recycling laws, etc., the disassemblable system as such has not yet been established. However, small appliances generate a massive amount of wastes as compared to large appliances. Accordingly, even if the recovery system of facilitated separation as in large appliances were to be adopted for small appliances, there would be a heavy burden of tasks of separation of these wastes, imposed on waste collectors, waste-disposal service vendors, and recycling operators. In other words, even if the system were to be in place to enable physical separation, as in Japanese Patent Publication No. H11-273962, such system may facilitate the work of recycling operators but cannot nonetheless reduce the overall burden involved in waste disposal and recycling of small appliances such as mobile phones. In particular, for example, there is a trend in supply and demand of mobile phones to the effect that consumers frequently replace them before reaching the end of their physical lifespan by purchasing ones with new functions. Accordingly, these old mobile phones turn into wastes one after another, and as such, there is a significant trend in generation of a massive amount of wastes thereby. Hence, there is a need to transfer some of the tasks of separation of such small appliances before they fall into the hands of waste collectors, waste-disposal service vendors, and recycling operators.

### DISCLOSURE OF THE INVENTION

With respect to products, including these small appliances, the present invention purports to provide a product easily separable into respective separable materials in the hands of a user of a product. Accordingly, before small appliances such as mobile phones are disposed and handed over to the waste collectors as waste, the present invention enables separation of waste to a certain degree and reduction of overall burden of waste disposal and recycling.

In order to solve these problems, the product herein comprises a connection member for materials to be separately recovered, and a detachment member for detaching said connection member. Now, a detachment member utilizes a mechanism of deforming a screw member using an explosion means, a melting means, or a shape-memory alloy.

### BRIEF DESCRIPTION OF THE DRAWINGS

Fig. 1 is an illustration of materials to be separated in a separately recoverable product.
Fig. 2 is an illustration of mechanism of a connection member.
Fig. 3 is an illustration of breaking and detaching a connection member by an explosion means.
Fig. 4 is an illustration of detaching a connection member by a resistance-heating means.
Fig. 5 is an illustration of mechanism of detaching said connection member by raising the temperature of the connection member including a screw member by a heating means so as to deform the shape to flatten the threads of said shape-memory alloy.
Fig. 6 is an illustration of a structure, which enables mixing of chemical substances at the part of a material 06A1 containing an explosive, where an explosive is a chemical substance which generates gas.
Fig. 7 is an illustration of Fig. 6, which shows the state of detachment of a connection member of a material 06A1 by way of mixing of chemical substances and generating of gas.
Fig. 8 is an illustration of using a fastener of a shape-memory alloy capable of hitching to the opening outlet by way of spreading the head portion thereof after going through the opening.

### BEST MODE FOR CARRYING OUT THE INVENTION

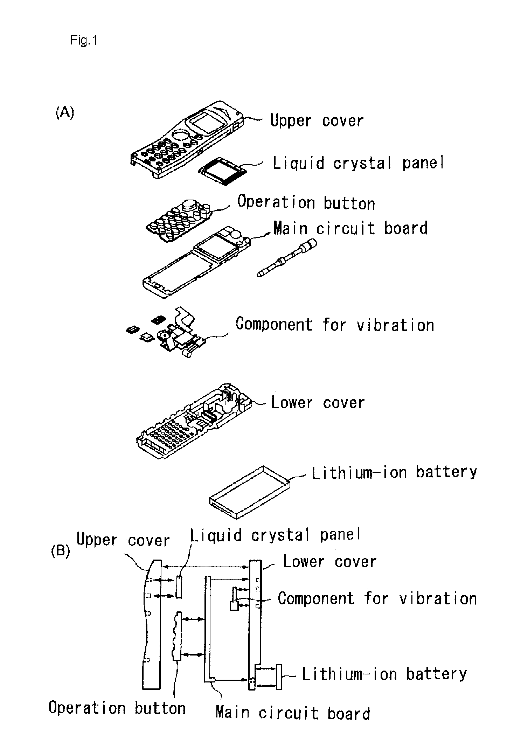

Hereinafter, the embodiments of the present invention will be described by using Figs. 1 to 5.

In relation to a product comprising a plurality of materials (e.g., a mobile phone), the present invention is a separately recoverable product, which is separable to its respective constituent components and materials. In other words, it is a product, which is disassemblable into respective separately recoverable materials.

As shown in Fig.1, in case of a mobile phone, for example, it is disassembled into an upper cover, a lower cover, and operation buttons, which are made of plastic materials respectively, and a liquid-crystal panel, a main circuit board, and vibration components, which include metal materials respectively.

### (Construction)

Mindful in particular of small appliances as in mobile phones generating a massive amount of waste, the present invention not only facilitates easy disassembly and separation by waste-disposal service vendors and recycling operators, it also provides a construction, which enables easy disassembly by a user of a mobile phone, etc. In particular, in order to enable disassembly into respective separately recoverable materials, the present invention is of construction of a separately recoverable product comprising a connection member and a detachment member. Hereinafter, the respective components thereof will be described.

### (Connection member)

First, a connection member will be described as below.

A connection member connects the separately recoverable materials. For example, in case of a mobile phone, a connection member connects respectively: (1) an upper cover made of a plastic material with a liquid-crystal panel containing a metal material; (2) operation buttons made of a plastic material with a main circuit board containing metal materials; and (3) a lower cover made of a plastic material with components containing metal materials, i.e., a main circuit board, components for vibration, and a lithium-ion battery.

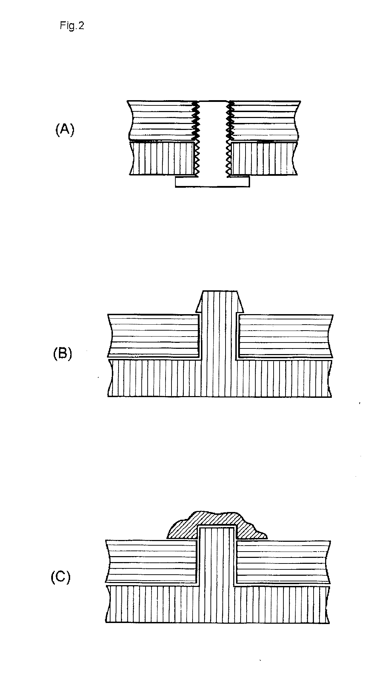

Fig. 2 is an illustration of connection mechanism of said connection member. As shown in Fig. 2, the connection mechanism of a connection member may include a screw structure (Fig. 2(A)), a press-fit structure (Fig. 2(B)), and a lead-solder connection structure (Fig. 2(C)). The engaged connection in the connection member is connected in a delicate manner, which can be detached by a minute physical action (an explosion mean) generated by an explosion for example by a small amount of an explosive. Below is described a method of breaking and detaching a connection member by an explosion means.

The "separately recoverable materials" are respective components of a product consisting of a plurality of components, which are separable by unit by a "process" during collection and waste disposal. Here, the "process" refers to crushing, melting, incinerating, etc. In particular, if one of the materials to be separated is a cover of a mobile phone formed of plastic, the "process" refers to a process of crushing it into small pieces after collection. Moreover, if another material to be separated is a main circuit board of a mobile phone, containing metal materials, the "process" refers to a process of removal by incinerating the materials other than the metal materials. In other words, separation is carried out by categorical unit of the same chemical properties, i.e., metal (iron, copper, aluminum, lead, etc.), glass, or plastic. Moreover, in addition to the simple separation by unit of the same chemical properties as above, the "process" may include provision for reuse by way of collection as unit of components composed of a plurality of materials of chemically different properties, e.g., a disposable camera case. In particular, in case of a disposable camera, a cover component formed of plastic material and a main circuit board for a flash unit is collected as a unit of components. Nevertheless, the materials to be separated are not to be limited to the above examples and may include any components as long as they are units of components generally handled by way of disassembly, etc.

Moreover, separately recoverable products according to the present invention are not limited to home appliances. For example, in the assembly of a PET bottle, the main body component of a PET bottle, which is formed of hard plastic materials, is covered with a soft film component. The soft film component, on which a package design is printed, is made of a thermal expandable material. In such cases, by expanding the film component by way of heating the PET bottle, this peels away the film component from the main body component by forming a gap there-between.

Nevertheless, the above PET bottle case is merely an example. The separately recoverable products according to the present invention are not limited to these embodiments, and could be any products as long as they are of construction using a plurality of separately recoverable materials. Examples other than the above embodiments include automobiles, and fabricated houses. The separately recoverable products many include any products as long as they are of construction enabling detachment via a detachment member without requiring a direct physical force manually onto the connection member connecting these separable materials.

### (Detachment member)

Next, a detachment member will be described.

The "detachment member" detaches said connection member in order to enable disassembly of respectively separable materials. The detachment member may include an explosion means, a melting means, and a heating means for deforming the members connected by a connection member of a shape-memory alloy deformable at a certain temperature. As described hereinafter, the detachment member may be formed as a part of a structure of separable materials forming into a connection member, or maybe formed separately from said connection member. In the former case, the connection member and the detachment member are integrated into a unit. Now, the detachment of said connection member by a detachment member does not necessarily mean complete detachment. In other words, it may refer to detachment of separation with other unseparated materials still remaining to the extent not hindering recycling of separable materials.

### (Explosion means)

The "explosion means" carries out detachment by breaking said connection member.

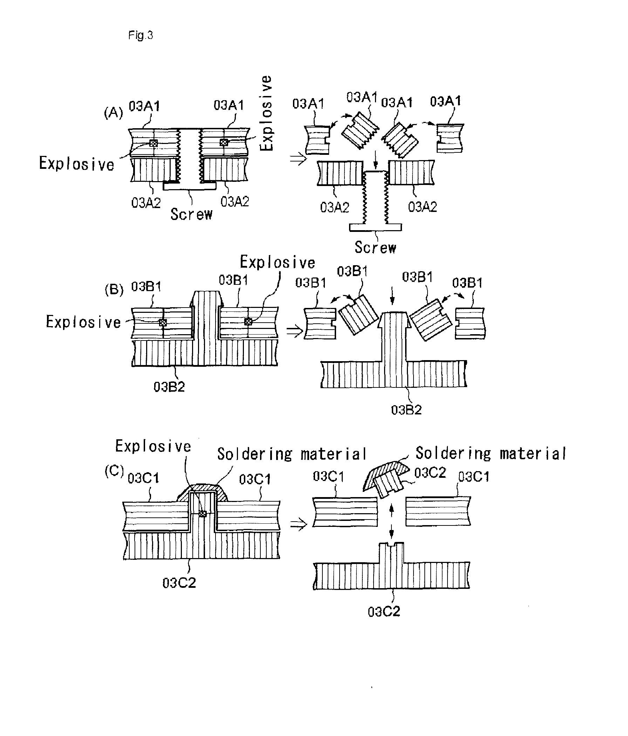

Fig. 3 is an illustration of a method for breaking said connection member by an explosion means. The explosion by the explosion means may utilize expansion effects by combustion or the like of combustible chemical substances. In such cases, the explosives used by the explosion means may include combustible chemical substances, such as oxidizable solid, combustible solid, inflammable liquid, self-reactive substances, combustible gas, etc. Examples of oxidizable solid include chloric salt, perchloric salt, inorganic peroxide, chlorite salt, bromate salt, nitrate, iodate, permanganate, dichlomate, etc. Examples of combustible solid include sulfide, red phosphorus, sulfur, and magnesium. Examples of inflammable liquid include petroleum, and alcohol. Examples of self-reactive substances include organic peroxide, nitrate ester, nitro compounds, nitroso compounds, azo compounds, diazo compounds, and hydrazine derivatives. Examples of combustible gas include methane, ethane, propane, butane, ethylene, propylene, and butylene. When using these combustible chemical substances, they may be combusted by means of heating or electrical ignition, or made to undergo chemical reaction by electrification. Moreover, the explosion by the explosion means may employ expansion effects of gas generated by chemical substances. In such cases, explosives used in the explosion means may include various types of chemical substances generating gas (e.g., hydrogen peroxide solution generating oxygen with addition of manganese dioxide). When using chemical substances generating gas as such, the expansion is accomplished by mixing these chemical substances therein. Now, in the description of the embodiments, the above "combustible substances" and "chemical substances generating gas" are time to time referred to as "explosives."

Fig. 3(A) is an illustration of detachment of a connection member, which is connected by a screw structure to separable materials (03A1, 03A2) by breaking a explosion means (a detachment member). The connection member and the explosion means prior to detachment are shown in the left side of Fig. 3(A). The connection member comprises materials (03A1, 03A2), and a screw. Moreover, in this case, the connection member is formed of a separable material 03A1 as a unit, and the explosion means is integrated into a unit with the connection member. One of the pieces of separable materials 03A1 comprises two or more section parts, between which there is space into which an explosive (including oxygen or the like required for combustion of an explosive) is placed. Materials 03A1 are formed in such a way that said explosive is sandwiched between the two section parts (formation of an explosion means). The two section parts having there-between an explosive for a material 03A1 may be pre-installed with a perforated line for facilitating detachment. To the separable material 03A1 formed with an explosion means, an opening is installed, and a screw thread is formed onto said opening. Moreover, an opening is installed into the separable material 03A2 connected to said separable material 03A1, but there is no screw thread on the opening of said material 03A2. Then, the two pieces of materials 03A1 and the material 03A2 are put together along the opening outlet, and are connected in such a way to allow screwing of a screw into said opening (formation of a connection member). In such a case, the explosive sandwiched between the separable materials 03A1 is exploded, and materials 03A1 are broken off to two pieces. In this manner, the screw is disengaged from the screw thread of the separable material 03A1, and the separable materials 03A1 are detached from the separable material 03A2. Now, although not illustrated in the drawings, as for means for exploding the explosive, where the explosive is a combustible chemical substance, a heating element of for example a nichrome wire may be installed in place to cause combustion by heating by said heating element by electrification of the part of the materials 03A1 with the sandwiched explosive. Further, the mechanism herein may be carried out by installing an electrode at the part of a material 03A1, followed by electrification.

Moreover, if the explosive is a chemical substance generating gas, a structure may be installed in place, in which said chemical substance can be mixed with the necessary substances at the part of the material 03A1 with the sandwiched explosive.

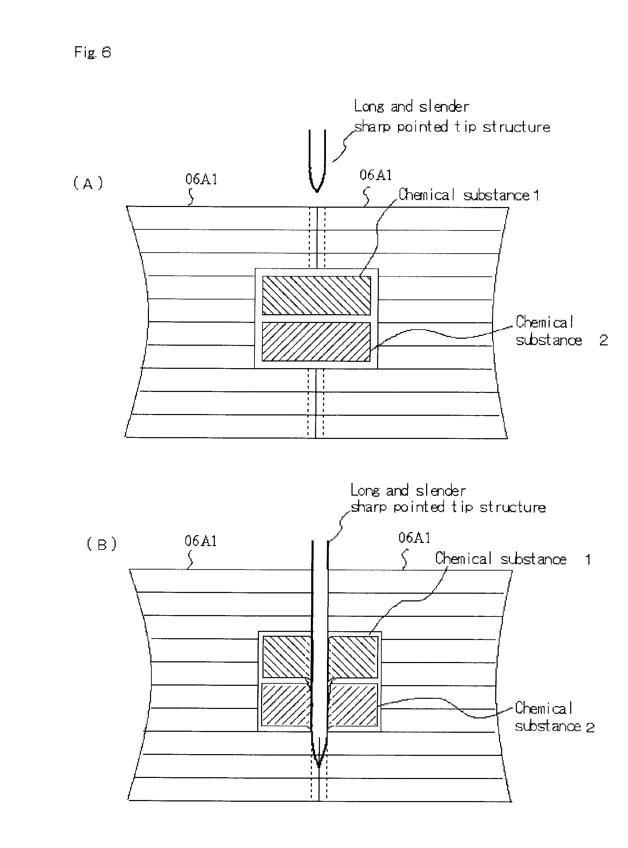

Fig. 6 is an illustration of a structure for enabling mixing of chemical substances at the part of materials 06A1 with the sandwiched explosive, where the explosive is a chemical substance generating gas. The explosive sandwiched between the materials 06A1 as shown in Fig. 6(A) comprises Chemical Substances 1 and 2. Chemical Substances 1 and 2 are stored in the respective vinyl vessels for example for disallowing pre-mixing. Fig. 6(B) illustrates an insertion of a long and slander sharp pointed tip structure (e.g., a needle) from the outer portion of the material 06A1 in order to mix Chemical Substances 1 and 2. A long and slander sharp pointed tip pierces and tears through the respective vinyl vessels for example of Chemical Substances 1 and 2, thereby enabling mixing of Chemical Substances 1 and 2, and generation of gas.

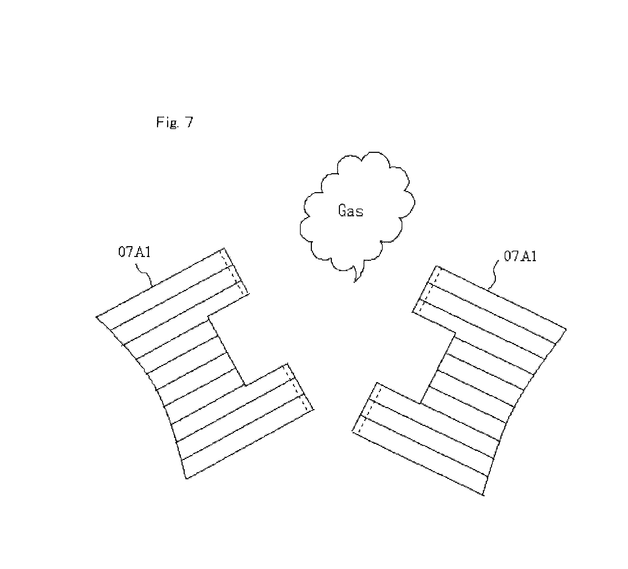

Fig. 7 is an illustration of detachment (07A1) of a material 06A1 of a connection member by way of generation of gas by mixing of Chemical Substances 1 and 2.

Moreover, Fig. 3(B) is an illustration of press-fit insertion of a protrusion part of a separable material 03B2 into the opening outlet installed on the separable material 03B2. Fig. 3(B) also illustrates an example of detachment by way of breaking the connection member press-fitted and connected with materials 03B1 and 03B2 by an explosion means. The connection member and the explosion means prior to detachment are shown in the left side of Fig. 3(B). The connection member comprises said materials 03B1 and 03B2, and the explosion means is formed as a part of a structure of said material 03B1. In such cases, the explosion means is formed as a part of a separable material of a connection member, which is integrated into the detachment and connection members. One of the pieces of separable materials 03B1 comprises two or more section parts, between which there is space into which an explosive (including oxygen or the like required for combustion of an explosive) is placed. Materials 03B1 are formed in such a way that said explosive is sandwiched between the two section parts (formation of an explosion means). The two section parts having there-between an explosive for the material 03A1 may be pre-installed with a perforated line for facilitating detachment. To the separable material 03B1 formed with an explosion means, an opening outlet is installed. Further, a protrusion part is installed on the separable material 03B2 to be connected to the separable material 03B1, wherein said protrusion part is press-fitted into the opening outlet of the material 03B1. Further, the width of the cross-section of an upper portion of said protrusion part is formed in such a way that it is wider than the width of the opening outlet of said material 03B1. Then, the protrusion part of the material 03B2 is inserted by press-fitting into the opening outlet of the material 03B1 while an upper portion of the protrusion part of the material 03B2 serves as a hitch, thereby connecting the material 03B1 with the material 03B2 (formation of a connection member). In such a case, the explosive sandwiched between the separable materials 03B1 is exploded, and breaks the materials 03B1 into two pieces. In this manner, the separable material 03B1 is disengaged from the separable material 03B2, thereby detaching the two. Now, the mechanism of exploding the explosive is identical to that illustrated in Fig. 3(A).

Moreover, Fig. 3(C) is an illustration of a connection member connecting a separable material 03C1 with a separable material 03C2 by soldering. Fig. 3(C) also illustrates an example of detachment by breaking the connection member connected with materials (03C1, 03C2) by an explosion means. The connection member and the explosion means prior to detachment are shown in the left side of Fig. 3(C). The connection member comprises said materials (03C1, 03C2), and the explosion means is formed as a part of a structure of said material 03C1. In such a case, the explosion means is formed as a part of a separable material of a connection member, which is integrated into the detachment and connection members. To the separable material 03C1, an opening is installed. Further, a protrusion part is installed on the separable material 03C2 to be connected to the separable material 03C1, wherein said protrusion part is press-fitted into the opening outlet of the material 03C1. Further, the protrusion part of the separable material 03C2 comprises two or more section parts, between which there is space into which an explosive (including oxygen or the like required for combustion of an explosive) is placed. The protrusion part of the separable material 03C2 is formed in such a way that said explosive is sandwiched between the two section parts (formation of an explosion means). The two section parts having there-between an explosive for the material 03C1 may be pre-installed with a perforated line for facilitating detachment. Then, the protrusion part of the material 03C2 is inserted into the opening outlet of the material 03C1, and the soldering is carried out in place to cover the portion in contact with the material 03C1 and the material 03C1, thereby connecting the material 03C1 to the material 03C2 (formation of a connection member). There, the explosive sandwiched between the separable materials 03C1 is exploded, and breaks the material 03B1 into two pieces. In this manner of explosion, the force tending to move away from the separable material 03C1 is acted upon the one side of the protrusion part of the separable material 03C2, and the soldering material thereby is peeled off from the material 03C1. In this manner, the separable material 03C1 is detached from the separable material 03C2. Now, the mechanism of exploding the explosive is identical to that illustrated in Fig. 3(A).

As described above, if the connection member is connected by a screw structure, or if the one material is connected to the other material of the connection member by press-fitting thereto, it may be too burdensome to disassemble the same by unscrewing a screw with a screw driver in the hands of a user of a separately recoverable product, or to detach the portion connected by press-fitting by manually pulling apart with hands. However, even when carried out by a user of a separately recoverable product, this may be easily carried out if the detachment is possible with breakage by an explosion means as above. Further, as described above, if the connection is made by soldering, it is much too burdensome to carry out detachment by heat-melting the connection member with a tool or the like in the hands of a user of a separately recoverable product. Moreover, with the advent of implementation of the recycling laws, there is a current trend for not using harmful substances such as soldering materials. For example, in lieu of lead which is generally used for soldering materials, under review is a use of tin (Sn), silver (Ag), copper (Cu), etc. as soldering materials. As for soldering materials of tin (Sn), silver (Ag), and/or copper (Cu), the melting point thereof is approximately 220°C, which is comparatively higher than the melting point of approximately 183 °C of the lead soldering materials. Accordingly, it is not so easy for a user of a separately recoverable product to carry out detachment of a connection member connected with the soldering materials of a high melting point as such. However, even in case of such a user, the detachment can be easily carried out if it is possible by breaking the connection member by an explosion member as described above.

### (A melting means, relating mainly to Claims 3 and 4)

The "melting means" detaches said connection member by melting.

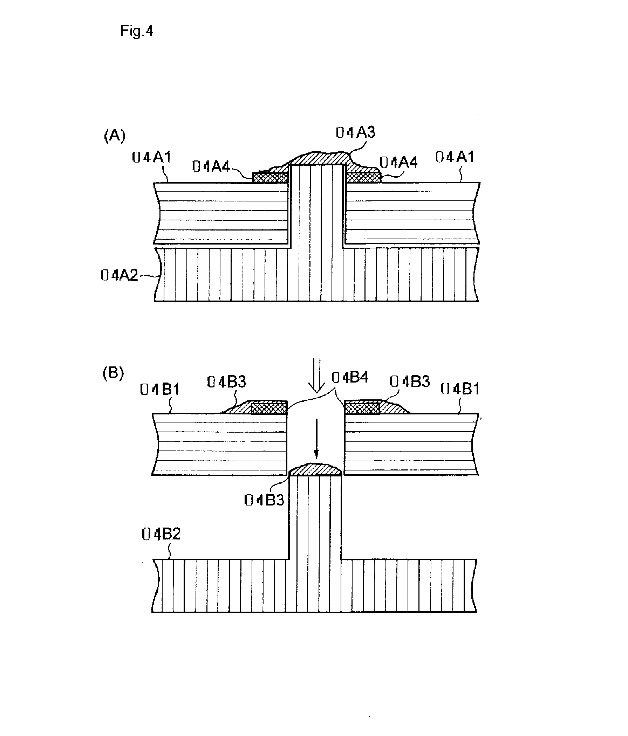

Fig. 4 is an illustration of a method of detachment of said connection member by said melting means. Fig. 4(A) illustrates for example a connection member connecting separable materials (04A1, 04A2), which are connected by soldering by a soldering material 04A3 of lead or the like containing soluble alloy. In such cases, a resistance-heating means can be installed as a detachment member, which enables heating by resistance therein. Fig. 4(B) is an illustration of post-detachment of said connection member detached by said resistance-heating means 04B4 (04A4 in Fig. 4(A) prior to heating). As shown in Fig. 4(B), the resistance-heating 04B4 enabling heating by resistance (04A4 in Fig. 4(A) prior to heating) melts the soldering material 0403 (04A4 in Fig. 4(A) prior to heating) by heating, thereby detaching said connection member of the separable material 04B1 (04A1 in Fig. 4(A) prior to heating) and the separable material 04B2 (04A2 in Fig. 4(A) prior to heating).

As a method of heating by said resistance-heating means, via having a conductive connection member as a heating element, there is a method of heating by direct electrification by installing an electrode at said connection member. Alternatively, there is a method of heating the connection member by radiation, conduction or convection from a heating element of a nichrome wire. Alternatively, there is a method of heating by far-infrared radiation. In this case, far-infrared radiation is generated by a heater having a resistance-heating element in contact with ceramics or the like. Then, the far-infrared radiation so generated oscillates the molecules of the soldering material of the connection member to be heated, thereby melting the connection member by heating the same by raising its temperature. A heater may be installed within or outside the separately recoverable product according to the present invention. If the heater is installed outside the separately recoverable product according to the present invention, a conductive wire, comprising substances of high heat-conductivity (copper, etc.), is put in place from said connection member to the outer case of the separately recoverable product according to the present invention for efficiently conducting heat to said connection member. In such a construct, the heat generated by the action of far-infrared radiation from the outer case of the separately recoverable product is transferred to the connection member by said conductive wire.

### (A heating means for deforming the component connected with a connection member using a shape-memory alloy, relating mainly to Claim 5)

Described next is a heating means for deforming the component connected with a connection member using a shape-memory alloy deforming at a certain temperature. A deforming member can be of any components as long as they are used for connection. For example, if a screw is used for connection, they made include components, such as a screw itself, an opening for screwing such screw, a washer inserted between the screw and a member formed with a threaded opening. Other than the screw, there may be used a rivet; or a fastener, in which the head portion thereof after going through an opening hitches to the opening outlet. Described below are a screw and a threaded opening.

The "heating means" carries out detachment by deforming the member connected with the connection member using a shape-memory alloy, which deforms at a certain temperature as above.

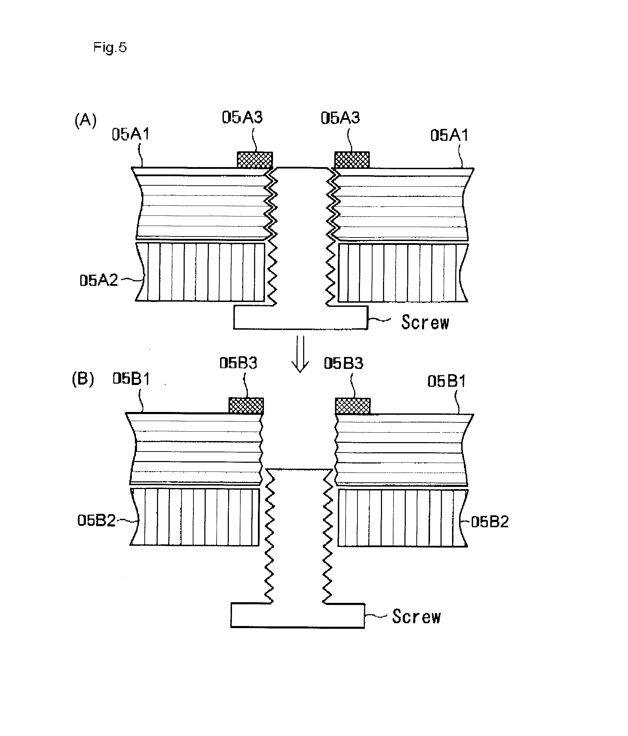

Fig. 5 is an illustration of detachment by deforming the member connected with the connection member using a shape-memory alloy, which deforms at a certain temperature. Fig. 5(A) illustrates said connection member, and a heating means prior to detachment. As shown in Fig. 5(A), an opening formed with a screw thread is installed onto the separable material 05A1, and an opening without formation of screw threads is installed onto to the other separable material 05A2. Then, the opening outlets of the material 05A1 and the material 05A2 are aligned and connected in place by a screw. Moreover, a heating means 05A3 is installed onto the portion of the separable material 05A1. Further, Fig. 5(B) illustrates post-detachment of said connection member detached by said heating means. As shown in 5(B), the heating means 05B3 (05A3 in Fig. 5(B) prior to heating) heats the temperature of said connection member (i.e., a portion formed with screw threads of the opening of the material 05A1) to the temperature of deforming the shape-memory alloy. The "temperature of deforming" refers to a temperature of deforming to the extent that it flattens the screw thread formed by the shape-memory alloy of the opening. In this manner, the screw thread is flattened, and the force for holding the screw into the opening is no longer available. Here, the screw thread of the opening is illustrated as having a shape-memory alloy, but the same result may be obtained by having a shape-memory alloy on the screw thread of the screw as opposed to the opening. Which mechanism to select is determined by economical considerations. For example, the selection could be made for the method requiring a lesser amount of expensive materials of a shape-memory alloy, or the method leading to easy manufacture.

A "shape-memory alloy" is an alloy, which returns to its original shape by phase transformation from a crystal structure (austenite phase) at high temperature to a crystal structure (martensite phase) at low temperature. It includes Ni-Ti alloy, Cu alloy (Cu-Zn-Al alloy, Cu-Al-Ni alloy), and Fe-based alloy.

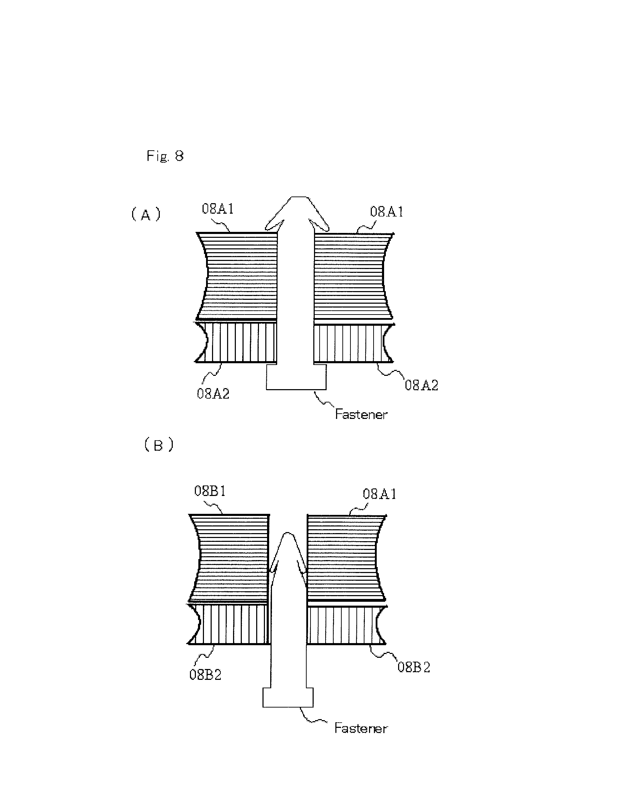

Fig. 8 illustrates a case of using a fastener, in which its head portion after going through the opening spreads and hitches to the opening outlet. In Fig. 8(A), the materials (08A1, 08A2) are hitched in place by a fastener. In Fig. 8(B), the fastener is heated by said heating means. By heating, the head portion of the fastener closes or unspreads, thereby facilitating detachment of the fastener.

### (Relating mainly to Claims 8 to 12)

Nonetheless, the present invention while being not limited by the embodiments as below may be constructed in such a manner to enable detachment of said connection member without having a detachment member comprising said heating means. The specific embodiments are provided below:
In relation to a separately recoverable product, enabling disassembly into respective separately recoverable materials, and further in relation to a connection member of separately recoverable materials, the separately recoverable product herein comprises a connection member, which is unconnected by an outside physical action and/or by chemical action. The physical action may include heating or electromagnetic radiation, and the chemical action may include contact with chemical liquid or specific gas.

Described below is one example of cases, in which physical action is heating. In the case of a connection member connected by a screw component using a shape-memory alloy, in which the screw thread thereof is flattened at a certain temperature, the separately recoverable product according to the present invention is structured in such a way to enable detachment of said connection member by heating by another device (a toaster, etc.), wherein the temperature of the connecting member comprising said screw component is raised to the temperature of deforming to the extent of flattening the shape-memory alloy screw thread.

Described next is one example of cases, in which physical action is electromagnetic radiation. In the case of a connection member connected by a screw component using a shape-memory alloy, in which the screw thread thereof is flattened by certain electromagnetic effects, the separately recoverable product according to the present invention is structured in such a way to enable detachment of said connection member by electromagnetic radiation by generating electromagnetic field to the extent of flattening the shape-memory alloy screw thread.

Described below is an example of detachment of said connection member by chemical action as above. In said connection member, a separable material is equipped with an opening, and the other separable material is equipped with a protrusion part, which is press-fitted into said opening outlet. By being inserted in place, the two separable materials are connected thereby. The hitching portion of the protrusion part is made of substances easily soluble by certain chemical solution or gas from the other separable material. In relation to the connection member as above, where the above chemical action involves contact with chemical liquid, the separately recoverable product according to the present invention is exposed to chemical liquid having an effect of melting only the material of the protrusion part. Then, by melting the protrusion part by said chemical solution, the connection member is disconnected, thereby enabling disassembly into respective separable materials. Moreover, in relation to the connection member as above, where the above chemical action involves contact with certain gas, the inside of the case of the separately recoverable product according to the present invention is filled with certain gas having an effect of melting only the material of the protrusion part. Then, by melting the protrusion part by certain gas, the connection member is disconnected, thereby enabling disassembly into respective separable materials.

### (Operation input member)

Moreover, the present invention may include an operation input member for using the function of said detachment member.

As described above, the "operation input member" enables input of signal for using the function of said detachment. For example, where the separately recoverable product is a mobile phone, the operation input member may comprise operation buttons for inputting a telephone number or the like of a mobile phone. Further, the operation buttons as such may comprise dedicated buttons installed separately. Further, while not being limited to the above construction of direct input by a user of a separately recoverable product, an input member for example may be constructed in such a way to enable inputting of said signal by receiving the signal transmitted via the Internet or the like.

By way of construction as above, while not undergoing disassembly by using a screw driver or the like, the disassembly of a mobile phone as such into separable materials may be carried out simply by a user of such mobile phone.

Moreover, the information specified based on the signal inputted to the operation input member may be of a pre-set password. For example, where the separately recoverable product is a mobile phone, the password may comprise numbers, characters, codes, etc., which are imputable by operation buttons of said mobile phone.

Then, by inputting the signal of the above password or the like to said operation input member, the detachment member detaches the connection member by means of operation based on the signal inputted from said operation input member. For example, by inputting the signal to said operation input member, the connection member is detached by breakage or otherwise of said connection member by an explosion means included in the detachment member.

### INDUSTRIAL APPLICABILITY

As described above, a separately recoverable product according to the present invention not only enables physical disassembly into separable components, but it also enables such disassembly in an easier manner. Further, if the disassembly is carried out as such, it facilitates separation at the level of users of separately recoverable products. In this manner, the costs associated with disassembly on the part of waste collectors, waste-disposal service vendors, and recycling operators, are suppressed, thereby facilitating recycling or the like.

Moreover, even if disassembly is carried out by waste collectors, waste-disposal service vendors, and recycling operators, the task becomes that much simpler for waste disposal and recycling. In particular, as described above, by having a connection member disconnected by an outside physical action or the like, the products to be disassembled are collected, and the connection members can be detached by putting physical action of heating or the like to the entire collection, thereby enabling all-at-once disassembly into separable materials. Further, from the perspective of electronic appliance makers, for example, in relation to the replacement or the like of a portion of defective products detected in the checking step prior to product shipment, the tasks for replacement for defective components will be facilitated by way of disassembly of products using the construct as described above.

## Claims

1. A separately recoverable product, which is disassemblable into respective separately recoverable materials, comprising: a connection member, which connects separately recoverable materials; and a detachment member, which detaches said connection member.

2. The separately recoverable product according to Claim 1, wherein said detachment member comprises an explosion means for breaking said connection member.

3. The separately recoverable product according to Claim 1, wherein said connection member comprises a soluble alloy; and said detachment member includes a melting mechanism for melting said connection member.

4. The separately recoverable product according to Claim 3, wherein said connection member comprises a soldering material; and said melting mechanism of said detachment member comprises a means of heating by resistance.

5. The separately recoverable product according to Claim 1, wherein said connection member comprises a screw member using a shape-memory alloy, in which threads are flattened at a given temperature; and said detachment member includes a heating means, which raises the temperature of said connection member with said screw member to the temperature of deforming the shape of said shape-memory alloy to the extent of flattening the screw threads.

6. The separately recoverable product according to any one of Claims 1 to 5, which comprises an operation input member for using a function of detachment of a detachment member, wherein said detachment member operates based on a signal inputted by said operation input member.

7. The separately recoverable product according to Claim 1, which further comprises a reception member, which receives operation code information for operating said detachment member, wherein said detachment member operates based on the operation code information received by said reception member for receiving operation code information.

8. A separately recoverable product, which is disassemblable to respective separately recoverable materials, comprising a connection member, which connects separately recoverable materials, and which is disassembled by a physical and/or chemical action inflicted from a source external to said connection member.

9. The separately recoverable product according to Claim 8, wherein said physical action involves heating.

10. The separately recoverable product according to Claim 8, wherein said chemical action involves electromagnetic radiation.

11. The separately recoverable product according to Claim 8, wherein said chemical action involves contact by chemical solution.

12. The separately recoverable product according to Claim 8, wherein said chemical action involves contact by specific gas.
